Europäisches Patentamt

European Patent Office

Office européen des brevets

(11) Numéro de publication: **0 138 759**
**A1**

## (12) DEMANDE DE BREVET EUROPEEN

(21) Numéro de dépôt: **84810414.7**

(22) Date de dépôt: **22.08.84**

(51) Int. Cl.⁴: **B 23 P 19/02**
// B23Q1/24

(30) Priorité: **26.08.83  CH 4691/83**

(43) Date de publication de la demande: **24.04.85**
**Bulletin 85/17**

(84) Etats contractants désignés: **IT**

(71) Demandeur: **C O D Inter Techniques SA, 16, rue Albert Gos, CH-1206 Genève (CH)**

(72) Inventeur: **Horvath, Laszlo S., 51, rte de Frontenex, CH-1207 Genève (CH)**

(74) Mandataire: **Vuille, Roman et al, c/o KIRKER & Cie S.A. 14, rue du Mont-Blanc Case Postale 872, CH-1211 Genève 1 (CH)**

(54) **Robot d'assemblage permettant d'appliquer une force à une pièce.**

(57)  Le robot comprend au moins un support (10) des pièces (11) dans une aire d'assemblage et une tête (1) portant l'outil d'assemblage (21). La tête est mobile en translation et/ou en rotation par rapport au support de pièces grâce à des supports de guidage (3) et est positionnée par des moteurs (6). La tête porte de façon fixe ou coulissante un dispositif (20) permettant d'appliquer l'outil (21) sur une pièce (11) avec une force déterminée.

Le robot comporte encore au moins une plateforme (15) placée face au support de façon que la tête (1) se trouve entre la plateforme et le support de pièces. La plateforme (15) est reliée mécaniquement au support de pièces par des éléments rigides (5) placés hors de l'espace entre l'aire d'assemblage et la plateforme, de façon à pouvoir résister à une force tendant à éloigner la plateforme du support.

## Robot d'assemblage permettant d'appliquer une force à une pièce

La présente invention a pour objet un robot d'assemblage de pièces de type soit manipulateur, soit non manipulateur. Elle a plus précisément pour objet un robot comprenant au moins un support des pièces dans une aire d'assemblage et une tête portant l'outil d'assemblage et mobile en translation et/ou en rotation par rapport au support de pièces grâce à des supports de guidage. La tête est positionnée par des moteurs et porte de façon fixe ou coulissante un dispositif permettant d'appliquer l'outil sur une pièce avec une force déterminée.

De nos jours, l'emploi des robots industriels se diversifie toujours plus: de nouvelles branches de l'industrie introduisent progressivement de tels robots dans des domaines jusqu'alors inexploités; d'autre part, les tâches confiées à ces robots évoluent elles-mêmes pour devenir plus complexes, plus délicates ou nécessiter plus de précision par exemple.

Certains robots doivent accomplir des tâches requérant l'emploi d'une force mécanique parfois importante. Si les structures mobiles d'un robot sont légères afin de permettre une grande vitesse de déplacement, elles ne sont pas capables d'absorber la réaction à une force d'application à la pièce. Au niveau des robots dits non manipulateurs, par exemple les robots-portiques, ce problème n'a pour l'instant trouvé aucune solution. Il s'ensuit que nombre de manipulations échappent ainsi au domaine des robots-portiques et nécessitent l'emploi d'instruments annexes, voire des actions purement manuelles. Dans ce cas, l'invention permet de combler avantageusement une telle lacune. Pour atteindre ce but, le robot selon l'invention est doté des caractères définis dans la revendication 1.

Les dessins ci-joints illustrent, à titre purement indicatif, certaines des exécutions de robots selon la présente invention ou le détail de certaines desdites exécutions. Il convient de noter à ce propos que la présente invention n'est en aucun cas limitée aux différentes exécutions ainsi illustrées.

Figure 1 est une vue de profil représentant l'une des exécutions de l'invention.

Figure 2 est une coupe du dispositif permettant d'appliquer une force à l'outil.

Figure 3 représente en coupe une autre forme d'exécution du dispositif permettant d'appliquer une force à l'outil.

Figure 4 est une coupe verticale d'une forme d'exécution préférée du robot selon l'invention.

Figure 5 est une vue en plan de la forme d'exécution du robot représenté à la fig. 4.

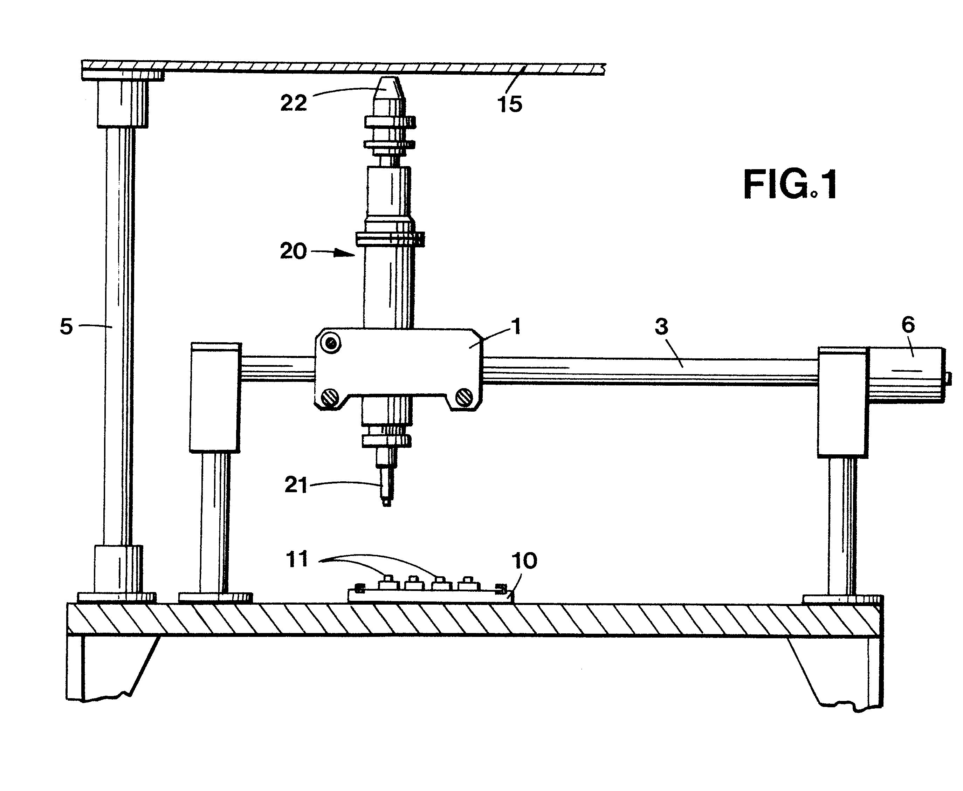

Tel que représenté dans son exécution illustrée par la figure 1, le robot selon l'invention comporte au moins un support 10 de pièces 11 dans une aire d'assemblage. Une tête 1 est mobile en translation et/ou en rotation, par exemple selon 2 ou 3 degrés de liberté, par rapport au support 10. La tête 1 se déplace sur des supports de guidage, dont un seul 3 est visible sur la figure 1, l'autre 4 étant agencé en profondeur. Un moteur 6 permet de déplacer la tête sur le support de guidage 3 visible sur la fig. 1. Un support de guidage pour un mouvement vertical de la tête est omis dans cette forme d'exécution, mais une autre forme d'exécution de l'invention peut parfaitement en être équipée.

Les divers mouvements de la tête de travail 1 sont engendrés et contrôlés à l'aide de composants usuels tels des servo-moteurs 6, entraînant des vis sans fin par exemple. La tête de travail 1 se déplace sur les supports de guidage de façon usuelle; le glissement sur les supports 3, 4 peut être assuré par exemple à l'aide de roulements conventionnels.

La commande de l'ensemble du robot peut être aussi réalisée de façon conventionnelle; elle est le plus généralement pneumatique, hydraulique ou électrique. L'ensemble du système est en outre généralement contrôlé par un ou plusieurs microprocesseurs, voire un ordinateur (non représentés).

Selon l'invention, le robot comporte un dispositif 20 permettant d'appliquer une force mécanique au travers d'un outil 21 à une pièce 11.

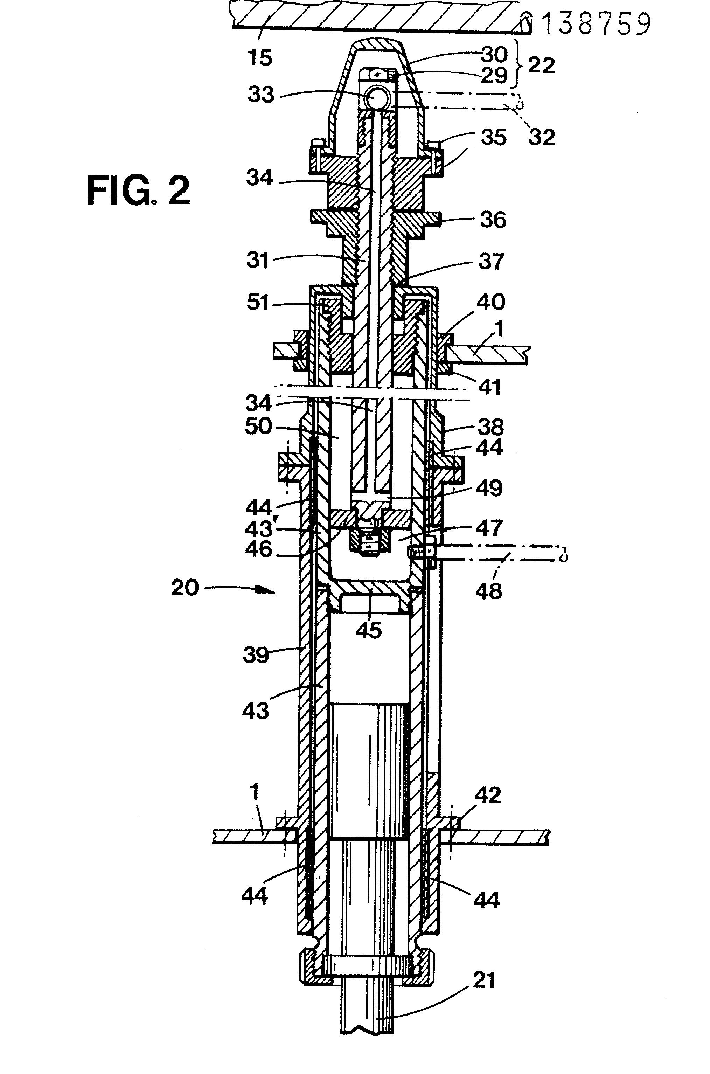

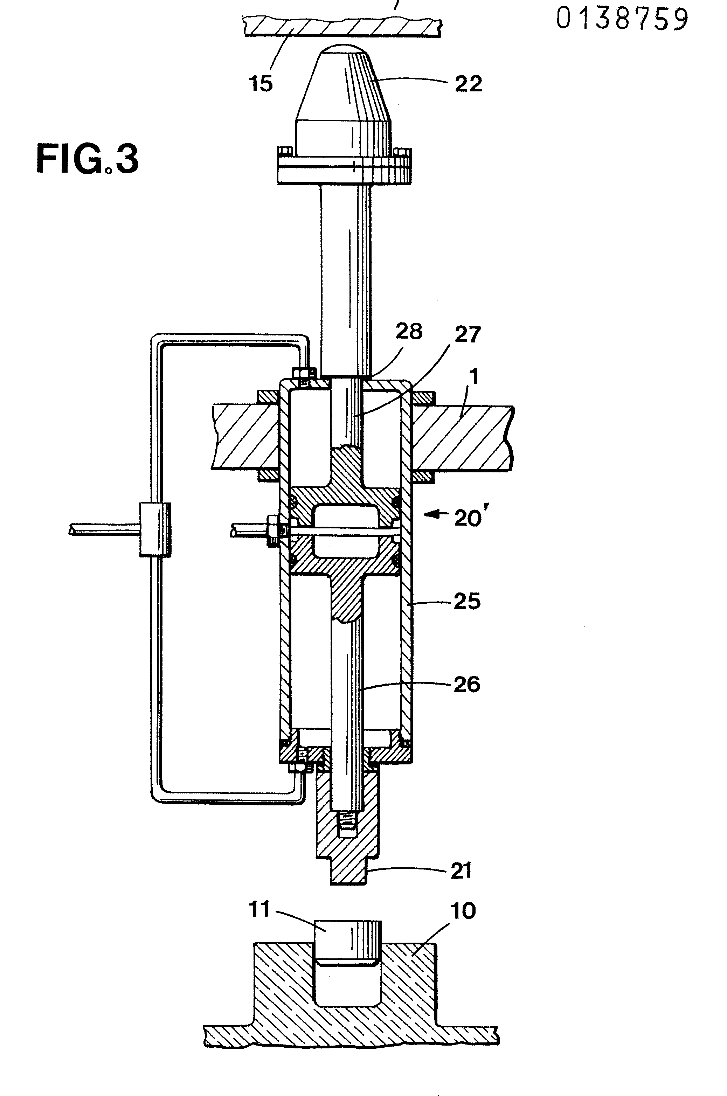

Ce dispositif peut être fixe par rapport à la tête, mais dans la forme d'exécution de la fig. 1, il est coulissant par rapport à la tête 5, et cela selon la direction de la force appliquée à la pièce. Des moyens permettant ce coulissement seront décrits ci-dessous à l'occasion de la description des fig. 2 et 3. Pour appliquer cette force à la pièce, le dispositif est équipé d'un vérin hydraulique, qui sera décrit en regard des fig. 2 et 3. Le vérin peut être commandé par des organes usuels pour développer une forme d'écartement déterminée entre ses extrémités, dont une porte l'outil 21 qui transmet la force d'application à une pièce 11 du support 10. La réaction à cette force s'exerce au travers d'une pièce d'appui 22 perpendiculairement à une plateforme 15 dont la fonction est d'absorber cette force de réaction. Dans ce but, la plateforme est reliée - au moins durant le temps d'application de la force - mécaniquement par des éléments rigides 5 au support 10 de pièces 11, pour résister à la force d'écartement créée par le vérin. On voit que lors de l'application de la force à la pièce 11, ni la force ni sa réaction s'exerçant sur la plateforme 15 ne créent une contrainte sur les supports de guidage 3,4. Ceux-ci peuvent donc être construits de façon légère pour permettre des déplacements rapides de la tête 1 du robot, ce qui permet d'obtenir une cadence de travail élevée, qu'il serait impossible d'atteindre avec une tête et des moyens de guidage lourds capables d'absorber eux-mêmes la réaction à la force d'application à la pièce.

La tête 1 peut porter en plus du dispositif 20 un appareil de préhension (non représenté) prenant une pièce ou un composant à un endroit de l'aire de travail et le déposant à un autre endroit et/ou sur une pièce avant que le dispositif 20 ne soit engagé pour exercer sa force sur la pièce.

Une construction préférée du dispositif 20 comportant le vérin est représentée à la figure 2.

Un capuchon protecteur 30 recouvre l'extrémité supérieure 29 d'une tige de piston 31 et forme avec elle la pièce d'appui 22. Au travers dudit capuchon passe un conduit de transmission pneumatique ou hydraulique 32 aboutissant au sommet 33 d'un canal 34 percé dans l'axe de la tige 31. La position du capuchon 30 sur ladite tige 31 est assurée par le moyen d'un écrou 35 et d'un contre-écrou 36. Le contre-écrou 36 sert aussi de bague de réglage venant buter en position inférieure à la surface 37 de la partie supérieure du boîtier tubulaire 38, 39. Dans sa partie supérieure, la fixation du dispositif 20 à la tête de travail 1 est assurée à l'aide d'une bague ou plusieurs bagues 40, 41 coopérant. Dans sa partie inférieure, le dispositif coopère avec la tête 1 par l'entremise d'un épaulement 42 aménagé à la surface de la partie inférieure du boîtier 38, 39.

A l'intérieur dudit boîtier coulisse un tube intérieur 43, 43' dont le glissement peut être entre autres assuré par des paliers 44. Solidarisé à la partie inférieure dudit tube 43, 43' à l'aide de tout dispositif approprié, se trouve l'outil 21. Dans sa partie médiane, ledit tube 43, 43' comporte une paroi interne étanche 45 dont l'étanchéité et la fixation sont assurées de façon usuelle (vis, joints, ...). Dans sa partie supérieure, au-dessus de ladite paroi étanche 45, ledit tube 43 comporte un piston 46 convenablement fixé à la base de la tige creuse 31 citée précédemment. C'est dans la chambre 47 ainsi aménagée qu'aboutit un second conduit de transmission pneumatique ou hydraulique 48.

Au-dessus du piston 46 aboutit le canal 34: par son ouverture 49, il est en communication avec la chambre 50. L'étanchéité de ladite chambre 50 peut être assurée dans sa partie supérieure par un écrou 51 ou tout autre dispositif analogue.

A l'exception du capuchon 30, des conduits 32 et 48 réalisés de préférence en un matériau plastique souple, les éléments constitutifs définis ci-dessus sont le plus généralement réalisés en métal. Les paliers 44, assurant le glissement du tube intérieur 43, 43', peuvent être soit en matière plastique, de préférence dure, soit en métal.

Les divers moyens annexes de commande tels que ressorts, soupapes, électro-valves par exemple, ne sont pas représentés. Ce sont des moyens connus, qui s'utilisent de façon conventionnelle.

Le fonctionnement du dispositif 20 permettant de créer une force mécanique est décrit ci-après. En un premier temps, une pression est exercée au travers du conduit 48 dans la chambre 47. Sous l'effet de ladite pression s'exerçant à la face inférieure du piston 46 solidaire de la tige 31, ladite tige subit un déplacement vertical vers le haut, tout comme les éléments 30, 35, 36 et 37 qui lui sont fixés. En fin de course ascensionnelle, l'extrémité supérieure de la tige 31 vient buter contre la plaque 15, le capuchon 30 faisant office de protection tant mécanique que phonique. Au cours de cette opération, aucune contrepression ne s'exerce dans la chambre 50. Simultanément, sous l'effet de la pression s'exerçant à la face supérieure de la paroi 45, le tube intérieur 43 porteur de l'outil 21 subit un déplacement vertical vers le bas, pour appliquer l'outil sur une pièce avec une force déterminée.

On voit que les parties actives du vérin 29, 30, 31 et 43, 43' coulissent dans le sens de la force d'écartement par rapport aux pièces 40, 42 fixant le vérin 20 à la tête 1.

Dans un second temps, une pression est exercée dans la chambre 50, au travers du conduit 32 et du canal 34, la pression première, exercée dans la chambre 47 étant simultanément relâchée, marquant ainsi la fin de la course descendante du tube 43, 43' et de son outil 21. Sous l'effet de la pression exercée à la face supérieure du piston 46, la tige 31 subit un déplacement vertical vers le bas pour revenir à sa position initiale, déterminée par la bague 36 butant sur la partie supérieure 37 du boîtier 38. Simultanément, sous l'effet de la pression s'exerçant à la face inférieure de l'écrou 51, le tube 43, 43' et son outil 21 subissent un déplacement vertical vers le haut pour retrouver également leur position initiale.

Cette succession d'opérations peut être répétée quasi indéfiniment; elle est le plus généralement commandée par le système de commande du robot.

La figure 3 représente un vérin 20' équipé de deux pistons opposés 26 et 27 dont les tiges portent respectivement la pièce d'appui 22 et l'outil 21. Le corps 25 peut maintenant être fixé de façon fixe, non coulissante à la tête 1. Les diamètres des pistons 26, 27 et de leurs chambres respectives sont égaux de sorte que les forces développées par les pistons sont égales et s'équilibrent, sans qu'une partie de la force ne s'exerce sur la tête 1.

On voit tant sur la figure 2 que sur la figure 3 une butée 28; celle-ci permet l'effet suivant lorsque le vérin se rétracte: dès que la pièce d'appui 22 s'est suffisamment éloignée de la plateforme 15, la butée 28 l'empêche d'être rétractée davantage et c'est la partie du vérin portant l'outil 21 qui est obligée de se rétracter. Ainsi l'outil s'éloigne de la pièce 11 placée sur le support 10, l'espace au-dessus de la pièce est dégagé, ce qui permet un accès facile, que ce soit pour l'inspection de la pièce ou pour son remplacement.

Dans la plupart des cas, mais ce n'est pas obligatoire, la tête 1 du robot se déplace selon des coordonnées cartésiennes et la force d'écartement agira également selon une troisième coordonnée cartésienne. La plateforme 15 étant perpendiculaire à la direction de la force d'écartement, la plateforme sera parallèle au plan de deux axes cartésiens. Souvent la plateforme 15 est montée de façon fixe.

Evidemment, dès que la force doit être appliquée à la pièce selon une autre direction, quelconque par rapport aux axes cartésiens, la réaction à la force doit être absorbée par une plateforme perpendiculaire à la direction de la force; si le travail exigé du robot d'assemblage exige plusieurs directions d'application de force, plusieurs plateformes à orientations différentes peuvent être prévues. Cette variante n'est pas représentée sur un dessin.

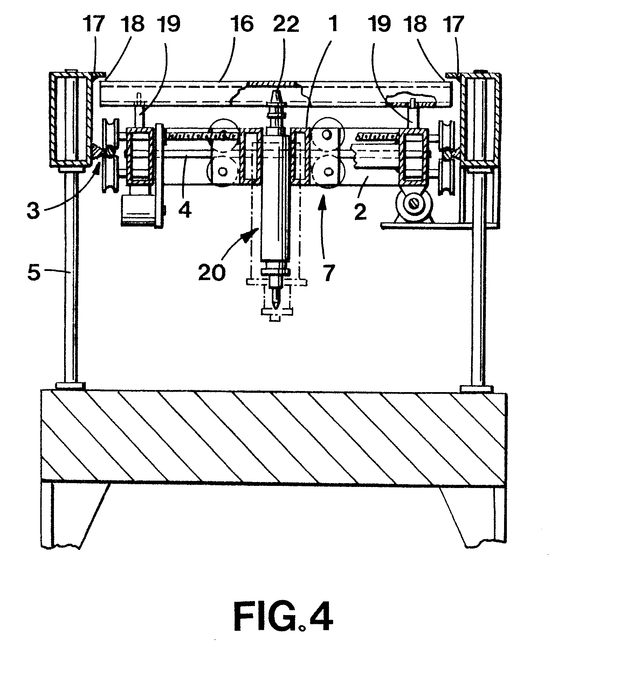

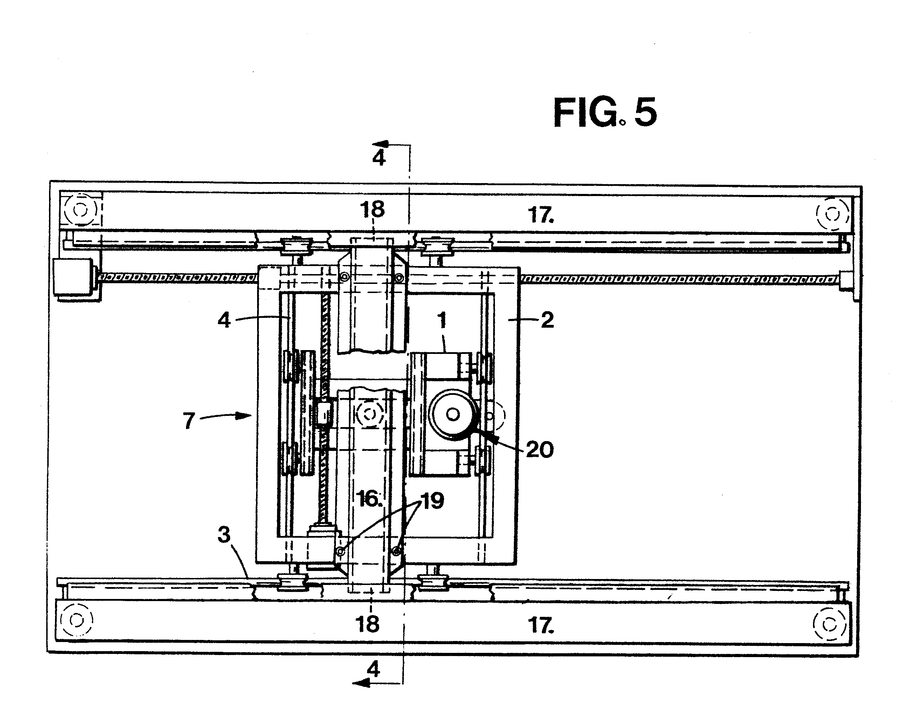

Une autre forme d'exécution de l'invention va être décrite en se référant aux figures 4 et 5, la figure 4 représente une coupe du robot selon la ligne 4-4 marquée sur la fig. 5. Pour alléger le robot, la plateforme et la structure rigide 5 qui la relie au support 10 des pièces 11, on ne prévoit pas une plateforme fixe pour toute l'aire de travail mais une plateforme 16 mobile selon une direction de translation ou de rotation. Cette plateforme mobile dans le cas d'une translation prend la forme d'une poutre mobile 16 bien visible à la figure 4. Dès que le vérin 20 exerce sa force d'écartement, la pièce d'appui 22 transmet la force de réaction à la poutre mobile 16, dont la section est en u renversé dans l'exécution de la figure 4. Les extrémités 18 de la poutre mobile 16 prennent alors appui sur les poutres fixes 17 qui résistent à la force d'écartement grâce aux éléments rigides 5 qui les relient au support 10 de pièces 11. Dès que le vérin 20 se rétracte, une fente s'établit entre les extrémités 18 de la poutre mobile et les poutres fixes; cette fente est bien visible à la figure 4; le déplacement de la poutre mobile 16 pour être maintenue face à la pièce d'appui 21 lorsque celle-ci se déplace, ne pose alors pas de problème. Pour simplifier, la poutre mobile 16 est déplacée en même temps que la tête 1 grâce à des moyens 18, par exemple tenons et trous coopérants ou bien "silent"-bloc flexible, de sorte que la poutre mobile 16 est entraînée transversalement en translation lors du déplacement de la tête sans toutefois transmettre à la tête 1 ou à ses supports de guidage 3, 4 un effort quelconque dû à la réaction à la force d'écartement.

On voit dans la forme d'exécution du robot selon les figures 4 et 5 que la tête se déplace sur un premier support de guidage 4, qui a la même direction que la poutre mobile 16. Ce premier support de guidage 4 est lui-même fixé le long d'un cadre ou chariot mobile 7 qui peut se déplacer perpendiculairement à la poutre mobile sur des seconds supports de guidage 3 fixés le long des

8

0138759

poutres fixes 17. Pour que la poutre mobile 16 soit maintenue face à la pièce d'appui 21 du vérin 20 de la tête 1,
il suffit que le cadre mobile 7 soit relié à la poutre
mobile 16 par des moyens 19, de façon à lui transmettre un
mouvement dans la direction des poutres fixes 17; un mouvement dans la direction de la force d'écartement ne doit
pas être transmis entre la poutre mobile 16 et le cadre
mobile 7, ce qui est facile à obtenir grâce à des tenons
et des trous 19 orientés correctement. Des moyens de liaison 19 présentant une grande flexibilité dans la direction
voulue comme des "silent"-blocs peuvent aussi être utilisés.

REVENDICATIONS                          0138759

1. Robot d'assemblage de pièces comprenant au moins un support (10) des pièces (11) dans une aire d'assemblage et une tête (1) portant l'outil d'assemblage (21), tête qui est mobile en translation et/ou en rotation par rapport au support de pièces grâce à des supports de guidage (3, 4) et est positionnée par des moteurs (6), cette tête portant de façon fixe ou coulissante un dispositif (20) permettant d'appliquer l'outil (21) sur une pièce (11) avec une force déterminée, caractérisé en ce que le robot comporte au moins une plateforme (15, 16) placée face au support de façon que la tête (1) se trouve entre la plateforme (15, 16) et le support de pièces (10) et capable d'être reliée mécaniquement au support de pièces par des éléments rigides (5) placés hors de l'espace entre l'aire d'assemblage et la plateforme (15, 16) de façon à pouvoir résister à une force tendant à éloigner la plateforme du support et que le dispositif (20) comporte une pièce d'appui (22) et un vérin agencé pour exercer, lorsque la tête (1) est immobile, une force d'écartement entre l'outil (21) et la pièce d'appui (22), la force étant transmise par l'outil (21) à la pièce (11) et la réaction à la force étant transmise par la pièce d'appui (22) perpendiculairement à la plateforme (15, 16), de façon que la tête (1) et ses supports de guidage (3, 4) ne sont soumis ni à la force ni à sa réaction.

2. Robot selon la revendication 1, caractérisé en ce que le vérin est un vérin alimenté par un fluide sous pression et que le dispositif (20) avec le vérin est porté de façon coulissante par la tête (1), la direction de coulissement étant celle de la force d'écartement.

3. Robot selon la revendication 1, caractérisé en ce que le vérin est un vérin alimenté par un fluide sous pression à deux pistons opposés (20') de même section, le corps du vérin étant fixé à la tête, une tige de piston (26) portant l'outil (21), la tige de l'autre piston (27) portant la pièce d'appui (22).

4. Robot selon l'une des revendications 1 à 3, caractérisé en ce qu'une butée (28) solidaire de la pièce d'appui (22) limite la course de la pièce d'appui lorsque le dispositif se rétracte, afin que l'outil (21) dégage l'accès aux pièces (11).

5. Robot selon l'une des revendications 1 à 4, caractérisé en ce que au moins deux des supports de guidage (3, 4) de la tête (1) sont agencés selon deux axes de coordonnées cartésiens, que la plateforme (15, 16) est parallèle au plan de ces deux axes, que la tête (1) se déplace selon un des axes cartésiens sur le premier (4) desdits deux supports de guidage, qui est fixé sur un cadre mobile (7) et que le cadre mobile se déplace selon l'autre des axes cartésiens sur le second (3) desdits deux supports de guidage.

6. Robot selon l'une des revendications 1 à 4, caractérisé en ce que la plateforme (16) est fixe.

7. Robot selon l'une des revendications 1 à 6, caractérisé en ce qu'il comporte plusieurs plateformes d'orientations distinctes.

8. Robot selon l'une des revendications 1 à 5, caractérisé en ce que la plateforme (16) est mobile par rapport au support (10) des pièces (11) selon au moins une direction de translation ou de pivotement commune avec une direction de mouvement de la tête (1) et en ce que le robot comporte des moyens (19) pour déplacer ensemble la tête (5) et la plateforme (16) selon cette direction commune.

9. Robot selon la revendication 8, caractérisé en ce que la plateforme est constituée par une poutre (16) mobile transversalement en translation, en ce que deux poutres fixes (17) sont reliées au support (10) des pièces (11) par les éléments rigides (5) placés hors de l'espace entre l'aire d'assemblage et la plateforme (16) et sont disposées perpendiculairement à la poutre mobile (16), de façon que chaque extrémité (18) de la poutre mobile (16) vienne s'appuyer sur une poutre fixe lorsque la force est appliquée par l'outil (21) sur la pièce (11) et que la force de réaction se transmet par la pièce d'appui (22) à la poutre mobile (16), et de façon que, lorsque la force n'est pas appliquée à l'outil, les extrémités (18) de la poutre mobile (16) sont séparées des poutres fixes (17)

0138759

par une fente permettant à des moyens d'entraînement de déplacer la poutre mobile transversalement et de la maintenir face à la pièce d'appui (22).

10. Robot selon les revendications 5 et 9, caractérisé en ce que les poutres fixes (17) sont parallèles au second support de guidage (3) sur lequel le cadre mobile (7) se déplace et en ce que des moyens coopérants (19) placés sur le cadre mobile (7) et la poutre mobile (16) sont agencés de façon à entraîner depuis le cadre mobile (7) la poutre mobile (16) en déplacement transversal sans que la réaction à la force appliquée à la pièce (11) ne soit transmise par la poutre mobile (16) au cadre mobile (7).

FIG.1

0138759

**FIG. 2**

FIG.3

3/5

0138759

**FIG.4**

FIG.5

5/5

0138759

# RAPPORT DE RECHERCHE EUROPEENNE

Office européen des brevets

0138759

Numéro de la demande

EP 84 81 0414

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | DE-B-1 133 964 (MÜLLER)<br>* En entier * | 1,5,8 | B 23 P 19/02 //<br>B 23 Q 1/24 |
| Y | * En entier * | 2,3 | |
| | --- | | |
| Y | DE-B-2 647 734 (SCHLEICHER)<br>* En entier * | 2,3 | |
| | ----- | | |

DOMAINES TECHNIQUES RECHERCHES (Int. Cl.4)

B 23 P
B 23 B
B 23 Q
F 15 B

Le présent rapport de recherche a été établi pour toutes les revendications

| Lieu de la recherche<br>LA HAYE | Date d'achèvement de la recherche<br>28-11-1984 | Examinateur<br>BERGHMANS H.F. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82